# EUROPÄISCHE PATENTSCHRIFT

(11) **EP 1 440 322 B1**
(45) Veröffentlichungstag und Bekanntmachung des Hinweises auf die Patenterteilung: **26.07.2006**
(21) Anmeldenummer: 02774691.6
(22) Anmeldetag: 08.10.2002
(51) Int. Cl.: G01P 15/08, B81B 7/02, B81C 3/00, G01P 1/02

(54) **MIKROSENSOR**
MICRO-SENSOR
MICROCAPTEUR

(30) Priorität: 29.10.2001 DE 10153319
(43) Veröffentlichungstag der Anmeldung: 28.07.2004
(73) Patentinhaber: austriamicrosystems AG, 8141 Unterpremstätten (AT)
(72) Erfinder: BRANDL, Manfred, A-8112 Gratwein (AT); CSERNICSKA, Robert, A-8510 Stainz (AT)
(74) Vertreter: Epping - Hermann - Fischer
(86) Internationale Anmeldenummer: PCT/EP2002/011256
(87) Internationale Veröffentlichungsnummer: WO 2003/038449

(56) Entgegenhaltungen:
- EP-A- 0 528 551
- EP-A- 0 772 045
- EP-A- 1 096 259
- US-A- 5 668 033
- US-A- 5 831 162

## Beschreibung

Die Erfindung betrifft einen Mikrosensor nach dem Oberbegriff des Patentanspruchs 1.

Ein Mikrosensor mit einer Lötverbindung statt einer eutektischen Verbindung ist beispielsweise aus DE 100 27 234 A1 bekannt. Hierin ist ein Mikrosensor mit einem integrierten Schaltkreis und einem darauf montierten mikromechanischen Sensorelement beschrieben. Das Sensorelement ist mechanisch und elektrisch durch eine umlaufende Lötnaht mit dem integrierten Schaltkreis verbunden. Ferner weist das Sensorelement zur Messung von Beschleunigungen einen Biegebalken auf, dessen Abstand zu dem integrierten Schaltkreis kapazitiv bestimmt und in ein Messsignal umgewandelt wird.

Bei einer solchen Anordnung stellt der Abstand des Sensorelements von dem integrierten Schaltkreis das Bezugssytem und die Referenz für die Positionsbestimmung des Biegebalkens dar. Eine Änderung des Abstands des Sensorelements zu der integrierten Schaltung würde das Messergebnis verfälschen und ist daher zu vermeiden.
Dies erfordert eine genau definierte und langzeitstabile Verbindung des Sensorelements mit dem integrierten Schaltkreis. Zur elektrischen Kopplung sollte die Verbindung zudem elektrisch leitfähig sein.

Bei einer Lötverbindung besteht die Gefahr, dass sich die Verbindung unter dem Einfluss mechanischer Spannungen verformt. Auch eine Alterung der Lötverbindung kann zu einer Lageveränderung des Sensorelements relativ zur dem integrierten Schaltkreis führen. Diese Gefahr wird durch eine Temperaturerhöhung, wie sie beispielsweise beim Auflöten des Mikrosensors auf eine Leiterplatte auftreten kann, deutlich erhöht.

Zudem erfordert die Herstellung einer Mehrzahl von Mikrosensoren mit Lötverbindungen im Waferverbund einen hohen technischen Aufwand, da viele Lötflächen gleichzeitig mit hoher Präzision miteinander verlötet werden müssen.

Weiterhin sind aus US 5,831,162, EP 0 528 551, EP 0 772 045 und EP 1 096 259 ähnliche Sensoren mit einer eutektischen Verbindung zwischen einzelnen Sensorkomponenten bekannt.

In US 5,668,033 ist ein Silizium-Bauelement beschrieben, das aus einem MOS-Transistor mit beweglichem Gate und einer Kappe aus Silizium besteht. Die beiden Teile werden durch eine eutektische Verbindung aus Gold und Silizium verbunden. Zwischen der Bondschicht und der Kappe ist eine Diffusionssperrschicht vorgesehen.

Der Erfindung liegt die Aufgabe zugrunde, einen Mikrosensor der eingangs genannten Art mit einer verbesserten Verbindung zwischen einem Sensorelement und einem integrierten Schaltkreis zu schaffen. Vorzugsweise soll der Mikrosensor im Waferverbund gefertigt werden können.

Diese Aufgabe wird durch einen Mikrosensor nach Patentanspruch 1 gelöst. Vorteilhafte Weiterbildungen der Erfindung sind Gegenstand der abhängigen Ansprüche.

Der Erfindung liegt die Idee zugrunde, ein vorzugsweise mikromechanisches Sensorelement mittels einer eutektischen Verbindung mit einem integrierten Schaltkreis (integrated circuit, IC) in Form eines Halbleiterchips zu verbinden. Insbesondere ist ein Sensorelement auf Siliziumbasis für eine eutektische Verbindung mit einem Silizium-Halbleiterchip, beispielsweise einem CMOS- oder BiCMOS-IC, geeignet.

Erfindungsgemäß ist vorgesehen, einen Mikrosensor mit einem Sensorelement und einem integrierten Schaltkreis, umfassend einen Halbleiterkörper mit einer integrierten Schaltung, zu bilden, wobei das Sensorelement auf einer Hauptfläche des Halbleiterkörpers angeordnet ist und zwischen dem Halbleiterkörper und dem Sensorelement eine.eutektische Verbindung ausgebildet ist, die zwischen zwei die Ausdehnung der eutektischen Verbindung festlegenden Barriereschichten angeordnet ist. Das Sensorelement ist ein mikromechanisches Sensorelement und umfasst eine bewegliche Komponente, aus deren Abstand zum Halbleiterkörper ein Messsignal erzeugt wird.

Eutektische Verbindungen, insbesondere eutektische Silizium-Gold-Verbindungen, zeichnen sich durch eine hohe mechanische Stabilität in einem weiten Temperaturbereich aus. Insbesondere sind derartige Verbindung mechanisch und thermisch stabiler als herkömmliche Lötverbindungen. Ein weiterer Vorteil besteht darin, dass eutektische Verbindungen sehr dünn ausgeführt werden können, so dass der hinsichtlich einer Lageveränderung kritische Bereich klein gehalten wird.

Bei einer vorteilhaften Ausgestaltung der Erfindung ist das Sensorelement aus einem Halbleitermaterial gebildet oder weist zumindest eine Halbleiterschicht oder ein Halbleitersubstrat auf. Die eutektische Verbindung kann in diesem Fall zwischen einer Halbleiteroberfläche des Sensorelements und einer Oberfläche des Halbleiterkörpers des integrierten Schaltkreises ausgebildet werden.

Hierzu ist bevorzugt der Halbleiterkörper auf der dem Sensorelement zugewandten Hauptfläche mit einer Metallschicht versehen. Die eutektische Verbindung wird in diesem Fall aus der Metallschicht und dem Halbleitermaterial des Sensorelements gebildet. Vorteilhafterweise wird so eine sehr kompakte Verbindung zwischen Sensorelement und Halbleiterkörper geschaffen, für die zudem nur eine geringe Zahl von Verbindungskomponenten benötigt wird. Alternativ kann auch das Sensorelement mit einer Metallschicht versehen und die eutektische Verbindung aus dem Material des Halbleiterkörpers und der Metallschicht des Sensorelements gebildet sein.

Vorzugsweise wird für einen integrierten Schaltkreis bzw. ein Sensorelement auf Siliziumbasis als Metallschicht eine Goldschicht oder eine Gold enthaltende Schicht verwendet. Als eutektische Verbindung dient hierbei ein Silizium-Gold-Eutektikum, das beispielsweise durch Aneinanderfügen einer Silizium- und einer Goldoberfläche bei erhöhter Temperatur und erhöhtem Druck ausgebildet werden kann.

Der Schmelzpunkt des Silizium-Gold-Eutektikums liegt mit 363 °C in einem vorteilhaften Temperaturbereich. Einerseits ist die Schmelztemperatur so niedrig, so dass die zur Ausbildung der eutektischen Verbindung erforderlichen Temperaturen für den integrierten Schaltkreis bei geeigneter Prozessführung unschädlich sind. Andererseits ist die Schmelztemperatur deutlich größer als die Maximaltemperatur, die üblicherweise beim Auflöten von Bauelementen auf Leiterplatten auftritt und die in der Regel zwischen 260 °C und 280 °C liegt. Dies gewährleistet, dass beim Auflöten die eutektische Verbindung nicht verändert oder gar gelöst wird. Gegebenenfalls kann durch eine an die eutektische Verbindung angrenzende, metallische Pufferschicht die Schmelztemperatur der eutektischen Verbindung durch Legierung mit der Pufferschicht noch erhöht werden.

Besonders bevorzugt basieren das Sensorelement und der integrierte Schaltkreis auf dem gleichen Halbleitermaterial. Eine im wesentlichen gleichartige Zusammensetzung des für das Sensorelement und für den integrierten Schaltkreis verwendeten Halbleitermaterials führt zu vorteilhaft geringen mechanischen Verspannungen zwischen dem Sensorelement und dem integrierten Schaltkreis, da beide Komponenten des Mikrosensors etwa denselben thermischen Ausdehnungskoeffizienten aufweisen.

Bei einer vorteilhaften. Weiterbildung der Erfindung ist die integrierte Schaltung auf der dem Sensorelement zugewandten Hauptfläche des Halbleiterkörpers oder in der Nähe dieser Hauptfläche ausgebildet. Dies ermöglicht zwischen der integrierten Schaltung und dem Sensorelement oder Elektroden, die dem Sensorelement zugeordnet sind, kurze elektrische Verbindungen, die sich allgemein durch kurze Signallaufzeiten und geringe Störanfälligkeit auszeichnen. Bei kapazitiver oder induktiver Aufnahme bzw. Übertragung eines Messsignals, beispielsweise durch dem Sensorelement zugeordnete Elektroden, sind kurze elektrische Verbindungen besonders vorteilhaft, da die parasitären Induktivitäten und Kapazitäten der elektrischen Verbindung vergleichsweise gering sind. Damit wird eine Verfälschung des Messsignals weitgehend unterdrückt.

Vorzugsweise ist die integrierte Schaltung von der bereits beschriebenen Metallschicht bedeckt, so dass das Sensorelement unmittelbar über der integrierten Schaltung angeordnet werden kann.

Zwischen der integrierten Schaltung und der Metallschicht kann eine Haftschicht angeordnet sein, die die Haftung der Metallschicht auf dem Halbleiterkörper bzw. auf der integrierten Schaltung erhöht. Vorteilhaft ist dabei eine elektrisch leitende Haftschicht, beispielsweise eine Titanschicht.

Weiter ist zwischen der integrierten Schaltung und der Metallschicht eine der Barriereschichten ausgebildet, die eine Diffusion von Atomen aus der Metallschicht in die integrierte Schaltung verhindert. Eine solche Earriereschicht ist vorteilhafterweise auch in dem Sensorelement ausgebildet.

Wird die eutektische Verbindung beidseitig von Barriereschichten eingefasst, so wird dadurch die Ausdehnung der eutektischen Verbindung festgelegt. Mit Vorteil kann so die Dicke der eutektischen Verbindung mit hoher Präzision eingestellt werden.

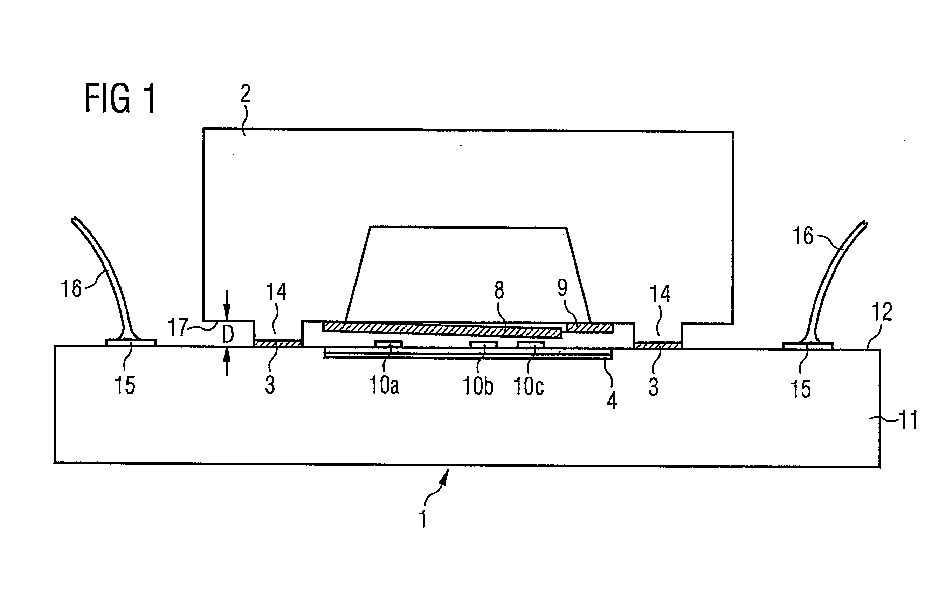

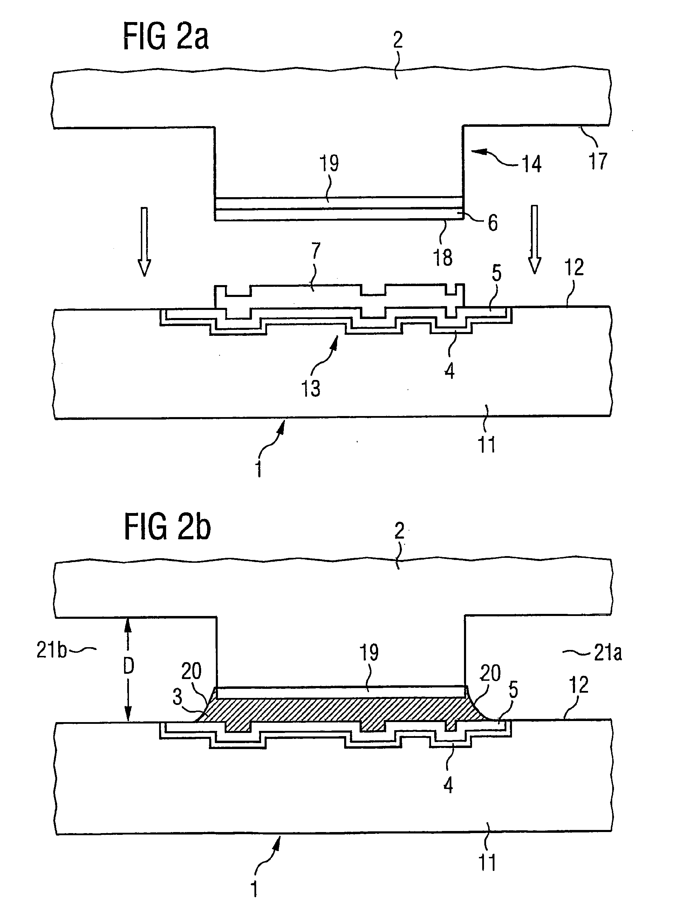

Weitere Merkmale, Vorzüge und Zweckmäßigkeiten der Erfindung ergeben sich aus den nachfolgend beschriebenen zwei Ausführungsbeispielen in Verbindung mit den Figuren 1 und 2.

Es zeigen
- Figur 1: eine schematische Schnittansicht des Ausführungsbeispiels eines erfindungsgemäßen Mikrosensors und
- Figur 2a und 2b: eine schematische Teilschnittansicht des Ausführungsbeispiels eines erfindungsgemäßen Mikrosensors vor und nach der Ausbildung der eutektischen Verbindung.

Gleiche oder gleich wirkende Elemente sind in den Figuren mit denselben Bezugszeichen versehen.

Der in Figur 1 dargestellte Mikrosensor weist einen integrierten Schaltkreis 1 und ein Sensorelement 2 auf. Der integrierte Schaltkreis 1 umfasst einen Halbleiterkörper 11 mit einer Hauptfläche 12 sowie eine integrierte Schaltung 4, die auf der Seite der Hauptfläche 12 ausgebildet ist.

Das Sensorelement 2 ist auf der Hauptfläche 12 angeordnet. Dazu ist das Sensorelement mit einem umlaufenden Vorsprung 14 auf die Hauptfläche 12 des Halbleiterkörpers 11 aufgesetzt und eine eutektische Verbindung 3 zwischen dem Vorsprung 14 und dem Halbleiterkörper 11 ausgebildet. Die eutektische Verbindung 3 wird im Zusammenhang mit Figur 2a und 2b noch genauer erläutert.

Das Sensorelement 2 ist bei dem gezeigten Ausführungsbeispiel als mikromechanisches Sensorelement für einen Beschleunigungssensor ausgeführt. Dazu weist das Sensorelement 2 eine bewegliche Komponente in Form eines Federstreifens 8 (schematisch in ausgelenkter Lage dargestellt) auf, der von einem umlaufenden, im montierten Zustand parallel zur Hauptfläche 12 angeordneten Rahmen 9 umgeben ist. Der Federstreifen 8 wird je nach Größe der einwirkenden Beschleunigung aus seiner Ruhelage ausgelenkt, so dass sich der Abstand des Federstreifens 8 zu der Hauptfläche 12 in Abhängigkeit der Beschleunigung ändert.

Dieser Abstand wird kapazitiv gemessen und mittels der integrierten Schaltung in ein elektrisches Messsignal umgewandelt.

Zur kapazitiven Messung sind dem Sensorelement zugeordnete und dem Federstreifen 8 gegenüberliegende Elektroden 10 vorgesehen, die beispielsweise als Referenzelektrode 10a, Messelektrode 10c und Aktuatorelektrode 10b fungieren können. Die Referenzelektrode 10a ist am fixierten Ende des Federstreifens 8 angeordnet, so dass sich der Abstand zum Federstreifen auch bei dessen Auslenkung nur geringfügig ändert. Die Messelektrode 10c ist hingegen dem anderen Ende des Federstreifens 8 gegenüberliegend und somit an einem Ort mit möglichst großer Auslenkung angeordnet. Über die Aktuatorelektrode 10b kann eine elektrostatische Kraft auf den Federstreifen 8 ausgeübt werden. Dies ermöglicht eine Einstellung der Ruhelage des Federstreifens 8. Weiterhin kann damit der Federstreifen stabilisiert und dessen Empfindlichkeit variiert werden.

Das an den Elektroden 10 anliegende, kapazitive Messsignal wird mittels der integrierten Schaltung aufbereitet. Die integrierte Schaltung kann dazu beispielsweise eine Mess-, Kalibrier- und/oder Kompensationsschaltung umfassen. Von der integrierten Schaltung aus wird das aufbereitete Messsignal über Leiterbahnen (nicht dargestellt), Anschlussflächen 15 und Drahtanschlüsse 16 zu externe Anschlüssen herausgeführt.

Für die Funktion des Mikrosensors und die Genauigkeit des Messergebnisses ist der Abstand D zwischen der Hauptfläche 12 und der gegenüberliegenden Fläche 17 des Sensorelements von entscheidender Bedeutung. Dieser Abstand D setzt sich zusammen aus der Höhe des Vorsprungs 14, der Dicke der eutektischen Verbindung 3 und gegebenenfalls der Dicke weiterer Zwischenschichten. Die Höhe des Vorsprungs und die Dicke weiterer Zwischenschichten kann mit Hilfe an sich bekannter Herstellungsverfahren wie beispielsweise Trockenätzen mit hinreichender Genauigkeit gefertigt werden. Da die eutektische Verbindung 3, wie bereits beschrieben, ebenfalls mit einer genau vorherbestimmten Dicke ausgebildet werden kann, kann ein vorgegebener Abstand D zwischen der Hauptfläche 12 und der gegenüberliegenden Fläche 17 bei der Fertigung sehr genau eingehalten werden.

Statt eines Federstreifens kann ein mikromechanisches Sensorelement zur Erfassung anderer Messgrößen auch andere bewegliche Komponenten aufweisen. Beispielsweise kann bei einem Drucksensor das Sensorelement an der Stelle des Federstreifens 8 eine dünne Membran, vorzugsweise eine Siliziummembran, enthalten, deren Durchbiegung kapazitiv oder induktiv gemessen wird. Zweckmäßigerweise ist dabei in dem Sensorelement eine Öffnung gebildet, so dass auf einer Seite der Membran der zu erfassende Umgebungsdruck herrscht. Auch andere, beispielsweise schwingungsfähige oder resonanzfähige mikromechanische Strukturen werden oftmals verwendet.

In Figur 2 ist das Ausführungsbeispiel der Erfindung im Detail dargestellt. Figur 2a zeigt das Sensorelement und den integrierten Schaltkreis eines Mikrosensors unmittelbar vor der Ausbildung der eutektischen Verbindung 3. Figur 2b zeigt eine entsprechende Darstellung des Mikrosensors mit ausgebildeter eutektischer Verbindung 3.

Bei dem gezeigten Ausführungsbeispiel weist die integrierte Schaltung 1 einen Halbleiterkörper 11 aus Silizium auf. Die integrierte Schaltung kann beispielsweise ein CMOS- oder BiCMOS-IC sein.

Das Sensorelement 2 ist ebenfalls aus einem Siliziumkörper gefertigt. Aufgrund der Wahl gleicher Materialien für die integrierte Schaltung und das Sensorelement besitzen diese Komponenten des Mikrosensors annähernd denselben thermischen Ausdehnungskoeffizienten, so dass bei Temperaturänderungen, insbesondere während einer Abkühlphase nach der Herstellung oder beim Verlöten des Mikrosensors, mechanische Verspannungen zwischen Sensorelement und integrierter Schaltung gering gehalten werden.

Für Mikrosensoren auf Siliziumbasis wird zur eutektischen Verbindung besonders bevorzugt ein Silizium-Gold-Eutektikum verwendet. Dieses Eutektikum zeichnet sich durch eine Schmelztemperatur aus, die mit 363 °C insbesondere so gering ist, dass bei geeigneter Prozessführung keine Schäden an dem integrierten Schaltkreis auftreten.

Weiterhin bildet ein Silizium-Gold-Eutektikum eine feste, korrosionsbeständige und mechanisch und thermisch langzeitstabile Verbindung aus. Die Verbindung ist vorteilhafterweise gasdicht und kann zur hermetischen Einkapselung des Mikrosensorinnenraums verwendet werden. Diese Eigenschaft ist insbesondere für Drucksensoren vorteilhaft. Beispielsweise kann eine an eine Membran grenzende Referenzzelle mittels der eutektischen Verbindung mit der Membran verbunden und so gasdicht und hermetisch verschlossen sein. Der zu messende Druck ergibt sich bei einer derartigen Anordnung aus der Durchbiegung der Membran gegenüber der Referenzzelle und dem darin herrschenden Referenzdruck. Durch die gasdichte hermetische Einkapselung mittels der eutektischen Verbindung wird ein zeitlich konstanter Referenzdruck gewährleistet.

Generell ist eine hermetische Einkapselung für Mikrosensoren mit kapazitiver Erzeugung des Messsignals vorteilhaft, um die dielektrischen Eigenschaften des eingeschlossenen Mediums konstant zu halten.

Statt eines Silizium-Gold-Eutektikums kann gegebenenfalls auch ein Silizium-Silber- oder ein Silizum-Aluminium-Eutektikum verwendet werden.

Zur Ausbildung der eutektischen Verbindung ist auf der Hauptfläche 12 des Halbleiterkörpers 11 eine Metallschicht 7, vorzugsweise eine Goldschicht, aufgebracht, Figur 2a. Die Metallschicht 7 kann beispielsweise chemisch oder galvanisch erzeugt, aufgedampft oder aufgesputtert werden, wobei gegebenenfalls zur lateralen Strukturierung eine geeignete Maskentechnik verwendet wird.

Die von der Metallschicht bedeckten Strukturen 13 können dabei sowohl Teile der integrierten Schaltung 4 als auch beispielsweise Leiterbahnen sein. Insbesondere eine umlaufende eutektische Verbindung zur Einkapselung des Mikrosensorinnenraums macht es in der Regel erforderlich, Leiterbahnen aus dem Mikrosensorinnenraum zu den außenliegenden Drahtanschlussbereichen zu führen. Bei einer entsprechenden Leiterbahnführung vom Bereich 21a in den Bereich 21b kreuzen die Leiterbahnen die Verbindungsrichtung der eutektischen Verbindung. Hierbei kann vorteilhafterweise die Metallschicht bzw. eutektische Verbindung auch Teile der Leiterbahnen bedecken, wobei eine elektrische Isolierung der Leiterbahnen, beispielsweise mit einer Oxidschicht, zweckmäßig ist.

Selbstverständlich kann die Metallschicht 7 auch unmittelbar auf die Hauptfläche 12 des Halbleiterkörpers 11 aufgebracht werden. Im folgenden ist unter den Strukturen 13 auch die Hauptfläche 12 des Halbleiterkörpers 11 zu verstehen.

Zwischen den Strukturen 13 und der Metallschicht 7 ist eine Barriereschicht 5 angeordnet. Diese Barriereschicht 5 verhindert ein Eindiffundieren von Metallatomen aus der Metallschicht 7 in die integrierte Schaltung 4 und definiert so auf der Seite des integrierten

Schaltkreises 1 die Ausdehnung bzw. Dicke der eutektischen Verbindung. Als Barriereschicht kann beispielsweise eine Siliziumoxid- oder Siliziumnitridschichten verwendet werden. Auch eine Metallschicht, die beispielsweise Palladium, Platin, Wolfram und/oder Titan enthalten kann, ist als Barriereschicht geeignet.

Weiterhin kann zwischen der Metallschicht 7 und den bedeckten Strukturen 13, vorzugsweise auf den bedeckten Strukturen 13, eine Haftschicht, beispielsweise eine Titanschicht, und/oder eine Pufferschicht, beispielsweise aus Aluminium oder einer Aluminiumlegierung, angeordnet sein (nicht dargestellt). Eine Haftschicht erhöht die Haftung der Metallschicht 7 auf den bedeckten Strukturen 13 und verbessert so in der Folge die Verankerung der eutektischen Verbindung mit dem integrierten Schaltkreis 1.

Das Sensorelement 2 weist auf der der Metallschicht 7 zugewandten Seite im Bereich der auszubildenden eutektischen Verbindung eine Halbleiteroberfläche zur Ausbildung eines Halbleiter-Metall-Eutektikums auf. Vorzugsweise wird diese Oberfläche von dem Sensorelement selbst oder einer auf das Sensorelement aufgebrachten Halbleiterschicht 6 gebildet. Die Halbleiterschicht 6 ist auf eine Barriereschicht 19, zum Beispiel aus Siliziumoxid, Siliziumnitrid, Wolfram, Titan, Palladium oder Platin, aufgebracht, die bei der Ausbildung der eutektischen Verbindung eine Ausbreitung von Atomen der Metallschicht in das Sensorelement limitiert.

Durch eine beidseitig Einfassung der eutektischen Verbindung durch die Barriereschichten 5 und 19 kann die Dicke der eutektischen Verbindung sehr genau festgelegt werden.

Bei einem Sensorelement auf Siliziumbasis dient zur Ausbildung der eutektischen Verbindung zweckmäßigerweise eine Siliziumoberfläche. Diese kann von dem Sensorelement selbst oder bevorzugt von einer darauf aufgebrachten Siliziumschicht gebildet werden. Als Barriereschicht eignet sich insbesondere eine Siliziumoxid- oder eine Siliziumnitridschicht.

Auf der dem integrierten Schaltkreis 1 zugewandten Seite ist bei dem Sensorelement wie bei dem in Figur 1.gezeigten Ausführungsbeispiel ein Vorsprung 14 ausgebildet. Dieser kann beispielsweise durch bereichsweise Abtragung geformt werden. Hierfür eignet sich besonders ein Trockenätzverfahren, bei dem der Abstand von der Oberfläche 18 des Vorsprungs 14 zu der geätzten Oberfläche 17 sehr genau festgelegt werden kann. Bei dem gezeigten Ausführungsbeispiel beträgt dieser Abstand etwa 4 µm.

Vorteilhafterweise wird die Dicke der Siliziumschicht so bemessen und auf die Dicke der Goldschicht abgestimmt, dass die die eutektische Verbindung bildende Siliziummenge und Goldmenge bereits in dem durch das Silizium-Gold-Eutektikum vorgegebenen stöchiometrischen Verhältnis vorliegen. Dieses stöchiometrische Verhältnis liegt bei 94 Gew.% Gold zu 6 Gew.% Silizium. Die entspricht bei gleicher Fläche einem Verhältnis der Dicke der Goldschicht zur Dicke der Siliziumschicht von 100 zu 52.

Zur Ausbildung der eutektischen Verbindung werden das Sensorelement und der integrierte Schaltkreis aneinandergefügt, so dass die Metallschicht 7 und die Halbleiteroberfläche 18 in Kontakt kommen. In an sich bekannter Weise bildet sich bei erhöhter Temperatur und/oder erhöhtem Anpressdruck zwischen der Metallschicht und der Halbleiteroberfläche die eutektische Verbindung aus.

Dabei verflüssigt sich die eutektische Phase zunächst und erstarrt schließlich zu einem einheitlichen eutektischen Gefüge, das die eutektische Verbindung 3 darstellt, Figur 2b.

Durch die Verflüssigung werden mit Vorteil Oberflächenrauhigkeiten und Unebenheiten der bedeckten Strukturen 13 ausgeglichen. Typischerweise sind Unebenheiten bis etwa 0,5 µm tolerabel. Weiterhin wird ein geringfügiger Teil des flüssigen Eutektikums in lateraler Richtung verdrängt und erstarrt in Form einer Hohlkehle 20. Die Dicke der eutektischen Verbindung beträgt beispielsweise etwa 1µm.

Die jeweiligen Prozessparameter zur Ausbildung der eutektischen Verbindung 3, insbesondere Anpressdruck und Temperatur, hängen von den beteiligten Materialien ab. Eine eutektische Silizium-Gold-Verbindung wird vorzugsweise bei Temperaturen zwischen 363 °C, der Schmelztemperatur des Eutektikums, und etwa 390 °C gebildet. Dabei kann durch eine geeignete Prozessführung eine weitgehend verspannungsfreie Verbindung ausgebildet werden. Voraussetzung hierfür sind gleiche Temperaturen von Sensorelement und integriertem Schaltkreis bei der Ausbildung der eutektischen Verbindung sowie ein möglichst geringer lateraler Temperaturgradient. Mit besonderem Vorteil kann eine Mehrzahl eutektischer Verbindungen gleichzeitig im Waferverbund ausgebildet werden.

Die Erläuterung der Erfindung anhand der beschriebenen Ausführungsbeispiele ist selbstverständlich nicht als Beschränkung der Erfindung hierauf zu verstehen.

## Patentansprüche

1. Mikrosensor mit einem Sensorelement (2) und einem integrierten Schaltkreis (1), umfassend einen Halbleiterkörper (11) mit einer integrierten Schaltung (4), wobei das Sensorelement (2) auf einer Hauptfläche (12) des Halbleiterkörpers (11) angeordnet ist, wobei zwischen dem Halbleiterkörper (11) und dem Sensorelement (2) eine eutektische Verbindung (3) ausgebildet ist, bei dem das Sensorelement (2) ein mikromechanisches Sensorelement ist und bei dem das Sensorelement (2) eine bewegliche Komponente umfasst, aus deren Abstand zum Halbleiterkörper (11) ein Messsignal erzeug bar ist,
**dadurch gekennzeichnet, dass**
die eutektische Verbindung (3) zwischen zwei die Ausdehnung der eutektischen Verbindung (3) festlegenden Barriereschichten (5, 19) angeordnet ist.

2. Mikrosensor nach Anspruch 1 ,
**dadurch gekennzeichnet, dass**
die integrierte Schaltung (4) auf der dem Sensorelement (2) zugewandten Seite des Halbleiterkörpers (11) ausgebildet ist.

3. Mikrosensor nach Anspruch 1 oder 2,
**dadurch gekennzeichnet, dass**
das Sensorelement (2) aus einem Halbleitermaterial gebildet ist oder eine Schicht (6) oder ein Substrat aus einem Halbleitermaterial aufweist.

4. Mikrosensor nach Anspruch 3,
**dadurch gekennzeichnet, dass**
der Halbleiterkörper (11) des integrierten Schaltkreises (1) und das Sensorelement (2) gleiche Halbleitermaterialien enthalten.

5. Mikrosensor nach Anspruch 4,
**dadurch gekennzeichnet, dass**
der Halbleiterkörper (11) des integrierten Schaltkreises (1) und das Sensorelement (2) Silizium enthalten.

6. Mikrosensor nach einem der Ansprüche 3 bis 5,
**dadurch gekennzeichnet, dass**
die eutektische Verbindung (3) aus einer auf der Hauptfläche (12) des Halbleiterkörpers (11) angeordneten Metallschicht (7) und dem Halbleitermaterial des Sensorelements (2) gebildet ist.

7. Mikrosensor nach einem der Ansprüche 3 bis 5,
**dadurch gekennzeichnet, dass**
die eutektische Verbindung (3) aus einer auf dem Sensorelement (2) angeordneten Metallschicht und dem Material des Halbleiterkörpers gebildet ist.

8. Mikrosensor nach Anspruch 6 oder 7,
**dadurch gekennzeichnet, dass**
die Metallschicht eine Goldschicht ist oder Gold enthält.

9. Mikrosensor nach Anspruch 7 oder 8,
**dadurch gekennzeichnet, dass**
die integrierte Schaltung (4) mit der Metallschicht (7) abgedeckt ist.

10. Mikrosensor nach einem der Ansprüche 6 bis 9,
**dadurch gekennzeichnet, dass**
zwischen der Metallschicht (7) und der integrierten Schaltung (4) eine der Barriereschichten (5) und/oder eine Haftschicht angeordnet ist.

11. Mikrosensor nach einem der Ansprüche 1 bis 10,
**dadurch gekennzeichnet, dass**
das Sensorelement (2) eine der Barriereschichten (19) aufweist.

12. Mikrosensor nach Anspruch 10 oder 11,
**dadurch gekennzeichnet, dass**
die Barriereschicht (5) zwischen der integrierten Schaltung (4) und der Metallschicht und/oder die Barriereschicht (19) des Sensorelements (2) Siliziumoxid oder Siliziumnitrid enthalten.

13. Mikrosensor nach einem der Ansprüche 1 bis 12,
**dadurch gekennzeichnet, dass**
die eutektische Verbindung (3) ein Silizium-Gold-Eutektikum enthält.

14. Mikrosensor nach einem der Ansprüche 1 bis 13,
**dadurch gekennzeichnet**, d a s s
das Messsignal induktiv oder kapazitiv aus dem Abstand erzeugt wird.

15. Mikrosensor nach einem der Ansprüche 1 bis 14,
**dadurch gekennzeichnet**, d a s s
die bewegliche Komponente ein Federstreifen (8), eine bewegliche Membran oder eine schwingungsfähige Struktur ist.

## Claims

1. A microsensor having a sensor element (2) and an integrated circuit (1), comprising a semiconductor body (11) with an integrated circuitry (4), the sensor element (2) being positioned on a main surface (12) of the semiconductor body (11), wherein an eutectic connection (3) is formed between the semiconductor body (11) and the sensor element (2), the sensor element (2) is a micromechanical sensor element, the sensor element (2) comprises a movable component from whose distance from the semiconductor body (11) a measurement signal is producible,
**characterized in that** the eutectic connection (3) is arranged between two barrier layers (5, 19) which determine the extension of the eutectic connection (3).

2. The microsensor according to claim 1,
wherein the integrated circuitry (4) is formed on the side of the semiconductor body (11) facing the sensor element (2).

3. The microsensor according to claim 1 or 2,
wherein the sensor element (2) is made of a semiconductor material or has a layer (6) or a substrate of a semiconductor material.

4. The microsensor according to claim 3,
wherein the semiconductor body (11) of the integrated circuit (1) and the sensor element (2) contain like semiconductor materials.

5. The microsensor according to claim 4,
wherein the semiconductor body (11) of the integrated circuit (1) and the sensor element (2) contain silicon.

6. The microsensor according to one of claims 3 through 5,
wherein the eutectic connection (3) is formed of a metal layer (7) placed on the main surface (12) of the semiconductor body (11) and the semiconductor material of the sensor element (2).

7. The microsensor according to one of claims 3 through 5,
wherein the eutectic connection (3) is formed of a metal layer placed on the sensor element (2) and the material of the semiconductor body.

8. The microsensor according to claim 6 or 7,
wherein the metal layer is a gold layer or contains gold.

9. The microsensor according to claim 7 or 8,
wherein the integrated circuitry (4) is covered by the metal layer (7).

10. The microsensor according to one of claims 6 through 9,
wherein a barrier layer (5) and/or an adhesion layer is arranged between the metal layer (7) and the integrated circuitry (4).

11. The microsensor according to one of claims 1 through 10,
wherein the sensor element (2) comprises a barrier layer (19).

12. The microsensor according to claim 10 or 11,
wherein the barrier layer (5) between the integrated circuitry (4) and the metal layer and/or the barrier layer (19) of the sensor element (2) contains silicon oxide or silicon nitride.

13. The microsensor according to one of claims 1 through 12,
wherein the eutectic connection (3) contains a silicon-gold eutectic.

14. The microsensor according to one of claims 1 through 13,
wherein the measurement signal is produced inductively or capacitively from the distance.

15. The microsensor according to one of claims 1 through 14,
wherein the movable component is a spring strip (8), a movable membrane or a structure capable of vibrating.

## Revendications

1. Microcapteur ayant un élément (2) formant capteur et un circuit (1) intégré comprenant un corps (11) semi-conducteur ayant un circuit (4) intégré, l'élément (2) formant capteur étant disposé sur une surface (12) principale du corps (11) semi-conducteur, dans lequel il est constitué entre le corps (11) semi-conducteur et l'élément (2) formant capteur un composé (3) eutectique dans lequel l'élément (2) formant capteur est un élément formant capteur micromécanique et dans lequel l'élément (2) formant capteur comprend un composant mobile, un signal de mesure pouvant être produit à partir de sa distance au corps (11) semi-conducteur,
**caractérisé en ce que**
le composé (3) eutectique est disposé entre deux couches (5, 19) formant barrière et fixant l'étendue du composé (3) eutectique.

2. Microcapteur suivant la revendication 1,
**caractérisé en ce que**
le circuit (4) intégré est constitué du côté du corps (11) semi-conducteur, qui est tourné vers l'élément (2) formant capteur.

3. Microcapteur suivant la revendication 1 ou 2,
**caractérisé en ce que**
l'élément (2) formant capteur est en un matériau semi-conducteur ou a une couche (6) ou un substrat en un matériau semi-conducteur.

4. Microcapteur suivant la revendication 3,
**caractérisé en ce que**
le corps (11) semi-conducteur du circuit (1) intégré et l'élément (2) formant capteur contiennent de mêmes matériaux semi-conducteurs.

5. Microcapteur suivant la revendication 4,
**caractérisé en ce que**
le corps (11) semi-conducteur du circuit (1) intégré et l'élément (2) formant capteur contiennent du silicium.

6. Microcapteur suivant l'une des revendications 3 à 5,
**caractérisé en ce que**
le composé (3) eutectique est formé d'une couche (7) métallique disposée sur la surface (12) principale du corps (11) semi-conducteur et du matériau semi-conducteur de l'élément (2) formant capteur.

7. Microcapteur suivant l'une des revendications 3 à 5,
**caractérisé en ce que**
le composé (3) eutectique est formé d'une couche métallique disposée sur l'élément (2) formant capteur et du matériau du corps semi-conducteur.

8. Microcapteur suivant la revendication 6 ou 7,
**caractérisé en ce que**
la couche métallique est une couche d'or ou contient de l'or.

9. Microcapteur suivant la revendication 7 ou 8,
**caractérisé en ce que**
le circuit (4) intégré est revêtu de la couche (7) métallique.

10. Microcapteur suivant l'une des revendications 6 à 9,
**caractérisé en ce que**
l'une des couches (5) formant barrière et/ou une couche d'accrochage est disposée entre la couche (7) métallique et le circuit (4) intégré.

11. Microcapteur suivant l'une des revendications 1 à 10,
**caractérisé en ce que**
l'élément (2) formant capteur allume des couches (19) formant barrière.

12. Microcapteur suivant la revendication 10 ou 11,
**caractérisé en ce que**
la couche (5) formant barrière entre le circuit (4) intégré et la couche (7) métallique et/ou la couche (19) formant barrière de l'élément (2) formant capteur contient de l'oxyde de silicium ou du nitrure de silicium.

13. Microcapteur suivant l'une des revendications 1 à 12,
**caractérisé en ce que**
le composé (3) eutectique contient un eutectique silicium-or.

14. Microcapteur suivant l'une des revendications 1 à 13,
**caractérisé en ce que**
le signal de mesure est produit inductivement ou capacitivement à partir de la distance.

15. Microcapteur suivant l'une des revendications 1 à 14,
**caractérisé en ce que**
le composant mobile est un ruban (8) élastique, une membrane mobile ou une structure susceptible d'osciller.
